# EUROPÄISCHE PATENTSCHRIFT

(11) **EP 0 991 110 B1**
(45) Veröffentlichungstag und Bekanntmachung des Hinweises auf die Patenterteilung: **05.10.2005**
(21) Anmeldenummer: 98810988.0
(22) Anmeldetag: 01.10.1998
(51) Int. Cl.: H01L 21/00

(54) **Halbleiter-Montageeinrichtung mit einem Chipgreifer**
Mounting assembly for semiconductors with a chip gripper
Dispositif de montage de semiconducteurs avec un organe préhenseur pour puces

(43) Veröffentlichungstag der Anmeldung: 05.04.2000
(73) Patentinhaber: ESEC Trading SA, 6330 Cham (CH)
(72) Erfinder: Vischer, Dieter, 6300 Zug (CH)
(74) Vertreter: Falk, Urs

(56) Entgegenhaltungen:
- PATENT ABSTRACTS OF JAPAN vol. 098, no. 003, 27. Februar 1998 -& JP 09 298210 A (MATSUSHITA ELECTRIC IND CO LTD), 18. November 1997 -& US 5 876 556 A (TAKANAMI)

## Beschreibung

Die Erfindung betrifft eine Halbleiter-Montageeinrichtung mit einem Chipgreifer der im Oberbegriff des Anspruchs 1 genannten Art.

Eine derartige, als "Pick-and-Place" bezeichnete Einrichtung wird als Bestandteil eines "Die Bonder" genannten Montageautomaten bei der Halbleitermontage verwendet. Sie dient dazu, die zahlreichen, gleichartigen Chips eines Wafers, die sich nebeneinander auf einem Träger befinden, nacheinander auf einem Substrat, z.B. einem metallischen Leadframe, zu montieren. Mit jeder Pick-and-Place-Bewegung koordiniert stellt jeweils der Wafertisch, auf dem sich der Chipträger befindet, einen nächsten Chip bereit, und ebenso wird das Substrat verschoben, um am zweiten Ort einen neuen Substratplatz bereitzustellen. Zum Abheben und nachfolgenden Ablegen der Chips ist der Chipgreifer in bekannter Weise heb- und senkbar, entweder zusammen mit der ganzen Einrichtung oder für sich allein relativ zur Einrichtung.

An Montageeinrichtungen dieser Art werden extrem hohe Anforderungen gestellt. Für die Weiterverarbeitung der montierten Chips müssen diese lagegenau auf dem Substrat positioniert werden, was ein entsprechend genaues Erreichen des zweiten Ortes durch den Chipgreifer verlangt und auch bereits das genaue Anfahren des ersten Ortes für das Abheben der Chips voraussetzt. Anderseits werden auch hohe Geschwindigkeiten bzw. kurze Taktzeiten verlangt, wodurch entsprechend hohe Beschleunigungen und Massenkräfte an den bewegten Teilen auftreten.

Zur Erzeugung der alternierenden Bewegungen des Chipgreifers werden bisher verschiedene Hebelmechanismen angewendet, die teilweise Kulissenführungen enthalten. Derartige Führungen sind wegen der an ihnen auftretenden, erheblichen Querkräfte für einen präzisen Bewegungsablauf nachteilig und müssen entsprechend gewartet werden. Bei einem anderen, aus der EP 923 111 bekannten Mechanismus sitzt der Chipgreifer am Ende eines hin und her schwenkenden Hebels, d.h. er erfährt entsprechend den Schwenkausschlägen des Hebels eine bogenförmige Bewegung, die jeweils in den Endlagen gestoppt werden muss, wobei eine starke Neigung zu Schwingungen besteht. Ein Nachteil solcher Hebelantriebe liegt darin, dass sie nur einen Transport des Chips um eine feste, vorbestimmte Strecke von einem Ort A zu einem Ort B erlauben. Bekannt sind auch Antriebe, bei denen der Chipgreifer mittels eines Zahnriemens angetrieben wird. Nachteilig ist hier die grosse Ungenauigkeit der Plazierung des Chips auf dem Substrat.

Aus der JP 09-298210 ist eine Montageeinrichtung der im Oberbegriff des Anspruchs 1 genannten Art bekannt. Diese Montageeinrichtung umfasst einen von einem Linearmotor angetriebenen Schlitten mit einem Chipgreifer. Die vertikale Position des Chipgreifers wird mechanisch über eine Kulissenführung gesteuert.

Der Erfindung liegt die Aufgabe zugrunde, eine Halbleiter-Montageeinrichtung vorzuschlagen, die den Transport des Chips bei hoher Genauigkeit der Plazierung über beliebige Strecken erlaubt.

Die genannte Aufgabe wird erfindungsgemäss gelöst durch die Merkmale der Ansprüche 1 und 5.

Nachfolgend wird ein Ausführungsbeispiel der Erfindung anhand der Zeichnung näher erläutert.

Es zeigen:
- Fig. 1, 2: Schnittdarstellungen einer Halbleiter-Montageeinrichtung,
- Fig. 3: die Anordnung von Magneten in einem Stator einer Antriebsvorrichtung,
- Fig. 4A, B: die vertikale Lage des Läufers im Stator in zwei verschiedenen Positionen, und
- Fig. 5: einen Voice Coil Motor.

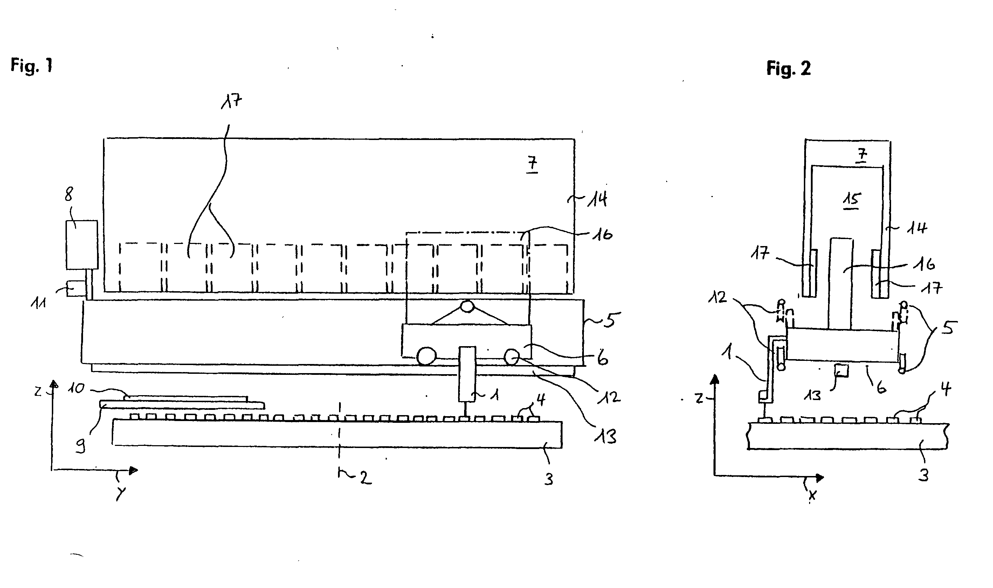

Die Fig. 1 und 2 zeigen schematisch zwei Schnittdarstellungen einer Halbleiter-Montageeinrichtung mit einem Chipgreifer 1, wobei die Schnitte in der yz- bzw. xz-Ebene eines kartesischen xyz-Koordinatensystems liegen. Der Übersichtlichkeit wegen sind nur die für das Verständnis der Erfindung nötigen Teile gezeichnet. Die Halbleiter-Montageeinrichtung umfasst einen, vorzugsweise um seine Mittelachse 2 drehbaren, und entlang der x-Achse verschiebbaren Wafertisch 3 zur Aufname eines in Chips 4 zersägten Wafers, einen aufeinem Rahmen 5 in y-Richtung bewegbaren Schlitten 6, eine erste Antriebsvorrichtung 7 zur Bewegung des Schlittens 6 in y-Richtung, eine zweite Antriebsvorrichtung 8 zur Bewegung des Rahmens 5 in vertikaler z-Richtung und eine Vorrichtung 9 zur Aufnahme und zum Transport eines Substrates 10. Die beiden Antriebsvorrichtungen 7, 8 sind ortsfest an der Halbleiter-Montageeinrichtung angeordnet. Vorzugsweise ist eine dritte, ebenfalls ortsfest angebrachte Antriebsvorrichtung 11 vorgesehen zur Verschiebung des Rahmens 5 und damit auch des Schlittens 6 mit dem Chipgreifer 1 um relativ kleine Distanzen in x-Richtung. Die Chips 4 befinden sich typischerweise auf einer als Nitto Tape bekannten Haftfolie, die in einem Rahmen aufgespannt ist.

Der Schlitten 6 rollt spielfrei auf Rädern 12 oder gleitet luftgelagert auf dem Rahmen 5. Zur präzisen Erfassung der jeweiligen Position des Schlittens 6 ist am Rahmen 5 ein Glasmassstab 13 angebracht, der mit einem am Schlitten 6 angeordneten Messkopf zusammenwirkt.

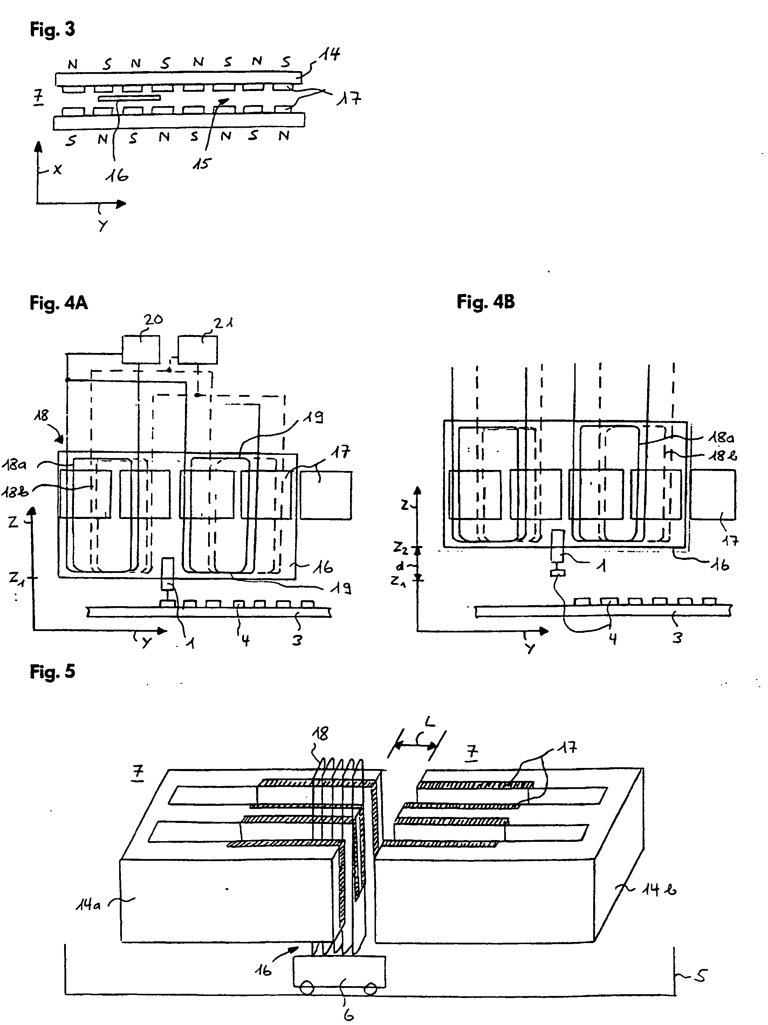

Die Antriebsvorrichtung 7 zur Bewegung des Schlittens 6 in y-Richtung ist ein u-förmiger Stator 14, in dessen Innenraum 15 sich ein am Schlitten 6 befestigter Läufer 16 erstreckt. Der Stator 14 weist beidseitig des Innenraumes 15, entlang der y-Richtung angeordnete Magnete 17 auf, die alternierend einen Nordpol N oder Südpol S darstellen. Einander gegenüberliegende Magnete 17 bilden jeweils ein Magnetpaar mit einem Nordpol N und einem Südpol S. Die Anordnung der Magnete 17 in der xy-Ebene ist in der Fig. 3 dargestellt. Der dem Innenraum 15 zugewandte Pol der Magnete 17 ist mit N für "Nordpol" und S für "Südpol" bezeichnet. Der Läufer 16 weist mehrere elektrische Wicklungen 18 (Fig. 4A) auf, die, in z-Richtung betrachtet, länglich sind. Mittels des Rahmens 5 ist der Läufer 16 in z-Richtung um eine Distanz d von typischerweise 3 cm bewegbar. Die in y-Richtung wirkende Antriebskraft ist bestimmt durch Richtung und Stärke des im Innenraum 15 des Stators 14 von den Magneten 17 erzeugten Magnetfeldes und von Richtung und Stärke der Ströme, die die Wicklungen 18 in vertikaler z-Richtung durchfliessen. Die Wicklungen 18 sind nun in z-Richtung länger als die Magnete 17 ausgebildet und zwar derart, dass sich bei einer Verschiebung des Läufers 16 um die Distanz d in z-Richtung die die Antriebskraft bestimmende Geometrie zwischen den Magneten 17 und den Wicklungen 18 nicht ändert. Die im Betrieb in y-Richtung auf den Läufer 16 wirkende Antriebskraft ist somit unabhängig von der z-Position des Läufers 16 bzw. des Schlittens 6. Die Fig. 4A zeigt die relative Lage der Wicklungen 18 zu den Magneten 17, wenn sich der Läufer 16 in einer z-Position z₁ befindet, bei der der Chipgreifer 1 gerade einen Chip 4 vom Wafertisch 3 aufnimmt. Die Fig. 4B zeigt die relative Lage der Wicklungen 18 zu den Magneten, wenn sich der Läufer 16 in einer z-Position z₂=z₁+d befindet, in der der Chip 4 vom Wafertisch 3 abgehoben ist und in y-Richtung transportiert wird.

Die Wicklungen 18 sind, wie in den Fig. 4A und 4B dargestellt, vorzugsweise rechteckförmig ausgebildet und so auf dem Läufer 16 angeordnet, dass sich die horizontal verlaufenden Stränge 19 der Wicklungen 18 ausserhalb des von den Magneten 17 im Innenraum 15 des Stators 14 erzeugten Magnetfeldes befinden. Somit ist gewährleistet, dass im Betrieb keine Kraft in vertikaler z-Richtung auf den Schlitten 6 ausgeübt wird. Für einen einwandfreien Betrieb ist die Antriebsvorrichtung 7 bevorzugt als 2-Phasen- oder 3-Phasen-Linearmotor ausgebildet. Bei einem 2-Phasen-Linearmotor sind jeweils Paare von Wicklungen 18a, 18b vorgesehen, wobei sich die beiden Wicklungen 18a, 18b eines Paares teilweise überlappen und wobei die beiden Wicklungen 18a, 18b eines Paares von verschiedenen Energiequellen 20, 21 gespeist werden. Ein wesentlicher Vorteil des Mehrphasen-Linearmotors ist darin zu sehen, dass er beliebig lang gebaut werden kann, wobei einzig dafür zu sorgen ist, dass der Stator 14 entweder genügend massiv ausgebildet ist oder auf der Basisstruktur der Halbleiter-Montageeinrichtung genügend fest verankert ist, damit die starken, von den Magneten 17 erzeugten Kräfte den Stator 14 nicht verbiegen können.

Zur Steuerung des Linearmotors wird das aus dem Glasmassstab 13 (Fig. 1) und dem Messkopf gebildete Positionsmesssystem verwendet. Die Wicklungen 18 sind über flexible Drähte fest mit den Energiequellen 20, 21 verbunden. Mechanische Kommutatoren zur Umpolung der Wicklungen 18 entfallen. An ihrer Stelle steuert ein Regler die Richtung, die Phase und die Amplitude der durch die Wicklungen 18 fliessenden Ströme entsprechend der Position, und ev. der Momentangeschwindigkeit, des Läufers 16 relativ zu den Magneten 17 des Stators 14, wobei diese Informationen wegen des Positionsmesssystems verfügbar bzw. ableitbar sind.

Bei einem anderen Ausführungsbeispiel ist, wie in der Fig. 5 in perspektivischer Darstellung illustriert ist, als Antriebsvorrichtung 7 ein Voice Coil Motor vorgesehen. Dieser Motor weist nur eine einzige Wicklung 18 auf, die aufgrund ihrer in z-Richtung ergiebigen Wicklung 18 in z-Richtung um die vorbestimmte Distanz d frei beweglich ist. Der Voice Coil Motor weist bevorzugt zwei in y-Richtung um die Distanz L getrennte E-förmige Statoren 14a, 14b auf, wobei die Wicklung 18 breiter als L ist, so dass sich immer ein Teil der Wicklung 18 in dem von den Magneten 17 erzeugten Magnetfeld befindet. Die Trennung in zwei Statoren 14a, 14b verlängert den Antriebsbereich in y-Richtung ohne merkliche Einbusse der Effizienz des Motors. Der Schlitten 6 und der Rahmen 5 sind nur schematisch skizziert. Im gezeichneten Beispiel bildet die am Schlitten 6 befestigte Wicklung 18 den Läufer 16.

Die Halbleiter-Montageeinrichtung dient dazu, einen Chip 4 nach dem anderen dem Wafertisch 3 (Fig. 1) zu entnehmen und auf dem Substrat 10 zu plazieren.

Bei einer bevorzugten Ausführung ist der Wafertisch 3 (Fig. 1) in einer einzigen horizontalen Richtung, nämlich der x-Richtung verschiebbar. Auch die Vorrichtung 9 zum Transport des Substrates 10 erlaubt nur einen Transport des Substrates 10 in x-Richtung. Der Schlitten 6 übernimmt den Transport der Chips 4 in y-Richtung. Vorteilhaft ist jedoch die dritte Antriebsvorrichtung 11 vorgesehen, die eine Verschiebung des Rahmens 5 und damit auch des Schlittens 6 mit dem Chipgreifer 1 in x-Richtung um einige zehn Mikrometer erlaubt. Die Transportvorrichtung 9 für das Substrat bewegt das Substrat 10 taktweise vorwärts in x-Richtung um eine vorbestimmte Strecke. Ebenfalls wird der Wafertisch 3 jeweils in x-Richtung verschoben, um den nächsten abzuarbeitenden Chip 4 bereitzustellen. Mittels der zweiten Antriebsvorrichtung 8 wird der Schlitten 6 in vertikaler z-Richtung angehoben und mittels der ersten Antriebsvorrichtung 7 in y-Richtung verschoben, bis sich der Chipgreifer 1 in einer vorgesehenen Position oberhalb des von einer nicht dargestellten Kamera bezüglich seiner xy-Lage exakt vermessenen Chips 4 befindet. Mittels der Antriebsvorrichtung 8 wird der den Schlitten 6 führende Rahmen 5 abgesenkt, bis der Chipgreifer 1 den Chip 4 mittels Vakkum von der Haftfolie abheben kann. Anschliessend wird der Rahmen 5 angehoben, der Schlitten 6 in y-Richtung transportiert und der Rahmen 5 wieder abgesenkt, bis der Chip 4 auf dem mittels einer zweiten Kamera oder eines Sensors vermessenen Substrat 10 plaziert ist. Eine geringe Abweichung der x-Lage des Chips 4 von seiner Solllage auf dem Substrat 10 wird dabei bereits während der Bewegung des Schlittens 6 mittels der dritten Antriebsvorrichtung 11 auskorrigiert. Da die Strecken, die der Schlitten 6 zurücklegen muss, je nach der y-Lage des Chips 4 auf dem Wafertisch 3 unterschiedlich lang sind, ergeben sich unterschiedlich lange Taktzeiten.

Falls der Wafertisch 3 um seine Mittelachse 2 drehbar ist, dann kann nach der Abarbeitung der Chips der ersten Hälfte des Wafers der Wafertisch um 180° gedreht werden und danach die zweite Hälfte des Wafers abgearbeitet werden. Dies erlaubt eine besonders kompakte Bauweise der Halbleiter-Montageeinrichtung, die auch für die Verarbeitung von Wafern mit einem grossen Durchmesser ausgelegt ist.

Die vorgeschlagenen Antriebsvorrichtungen kombinieren hohe Plazierungsgenauigkeit der Chips auf dem Substrat und grosse Freiheit in der Wahl des Substrates. Insbesondere können sowohl sehr schmale als auch sehr breite Substrate bei hoher mittlerer Taktrate problemlos verarbeitet werden. Die Antriebsvorrichtungen sind zudem weitgehend wartungsfrei, da sich der Stator und der Läufer nicht berühren. Zudem benötigen weder die Vorrichtung zum Transport der Substrate noch der Wafertisch zwingend einen Antrieb zu deren Verschiebung in y-Richtung.

Denkbar ist auch eine Lösung, bei der die Magnete 17 (Fig. 4A) um mindestens die Distanz d länger als die Wicklungen 18 ausgebildet sind, wobei sich die horizontalen Stränge 19 der Wicklungen 18 immer in dem von den Magneten 17 im Innenraum 15 des Stators 14 erzeugten Magnetfeld befinden. Auch hier ist die auf den Läufer 16 wirkende Antriebskraft invariant bezüglich einer Verschiebung des Läufers 16 in z-Richtung. Diese Lösung hat aber den Nachteil, dass die von den Magneten 17 erzeugten Kräfte bei gleicher Antriebsleistung stärker sind als bei den Lösungen, bei denen die Wicklungen 18 länger als die Magnete 17 ausgebildet sind.

## Patentansprüche

1. Halbleiter-Montageeinrichtung mit einem auf einem Rahmen (5) in einer horizontalen Richtung beweglichen Schlitten (6) und einer ersten Antriebsvorrichtung (7) zur Bewegung des Schlittens (6) auf dem Rahmen (5), wobei am Schlitten (6) ein Chipgreifer (1) befestigt ist, **dadurch gekennzeichnet, dass** die erste Antriebsvorrichtung (7) einen Magnete (17) aufweisenden Stator (14) und einen mit elektrischen Wicklungen (18) versehenen, am Schlitten (6) befestigten Läufer (16) umfasst, dass der Rahmen (5) mit einer zweiten Antriebsvorrichtung (8) in vertikaler Richtung bewegbar ist, dass der Läufer (16) sich in vertikaler Richtung in den Stator (14) erstreckt und dass die Wicklungen (18) des Läufers (16) in vertikaler Richtung länger als die Magnete (17) ausgebildet sind, damit sich bei einer Verschiebung des Läufers (16) in vertikaler Richtung um eine vorbestimmte Distanz (d) die die Antriebskraft bestimmende Geometrie zwischen den Magneten (17) und den Wicklungen (18) nicht ändert.

2. Halbleiter-Montageeinrichtung nach Anspruch 1, **dadurch gekennzeichnet, dass** der Stator (14) u-förmig ist und dass sich der Läufer (16) in dessen Innenraum (15) erstreckt.

3. Halbleiter-Montageeinrichtung nach Anspruch 1, **dadurch gekennzeichnet, dass** die erste Antriebsvorrichtung (7) als Voice Coil Motor ausgebildet ist.

4. Halbleiter-Montageeinrichtung nach Anspruch 3, **dadurch gekennzeichnet, dass** die erste Antriebsvorrichtung (7) zwei getrennte Statoren (14a, 14b) aufweist.

5. Halbleiter-Montageeinrichtung mit einem auf einem Rahmen (5) in einer horizontalen Richtung beweglichen Schlitten (6) und einer ersten Antriebsvorrichtung (7) zur Bewegung des Schlittens (6) auf dem Rahmen (5), wobei am Schlitten (6) ein Chipgreifer (1) befestigt ist, **dadurch gekennzeichnet, dass** die erste Antriebsvorrichtung (7) einen Magnete (17) aufweisenden Stator (14) und einen mit elektrischen Wicklungen (18) versehenen, am Schlitten (6) befestigten Läufer (16) umfasst, dass der Rahmen (5) mit einer zweiten Antriebsvorrichtung (8) in vertikaler Richtung bewegbar ist, dass der Läufer (16) sich in vertikaler Richtung in den Stator (14) erstreckt und dass die Magnete (17) in vertikaler Richtung länger als die Wicklungen (18) des Läufers (16) ausgebildet sind, damit sich bei einer Verschiebung des Läufers (16) in vertikaler Richtung um eine vorbestimmte Distanz (d) die die Antriebskraft bestimmende Geometrie zwischen den Magneten (17) und den Wicklungen (18) nicht ändert.

6. Halbleiter-Montageeinrichtung nach Anspruch 5, **dadurch gekennzeichnet, dass** der Stator (14) u-förmig ist und dass sich der Läufer (16) in dessen Innenraum (15) erstreckt.

## Claims

1. Semiconductor mounting apparatus with a slide (6) movable on a frame (5) in a horizontal direction and a first drive device (7) for moving the slide (6) on the frame (5), whereby a chip gripper (1) is secured to the slide (6), **characterized in that** the first drive device (7) comprises a stator (14) having magnets (17) and a coil part (16) with electrical windings (18), wherein the coil part (16) is secured to the slide (6), that the frame (5) is movable in vertical direction by means of a second drive device (8), that the coil part (16) projects in vertical direction into the stator (14) and that the windings (18) are formed in vertical direction longer than the magnets (17) so that the geometry between the magnets (17) and the windings (18) determining the drive force does not change on movement of the coil part (16) by a predetermined distance (d) in vertical direction.

2. Semiconductor mounting apparatus according to Claim 1, **characterized in that** the stator (14) is U-shaped and that the coil part (16) projects into its interior space (15).

3. Semiconductor mounting apparatus according to Claim 1, **characterized in that** the first drive device (7) is formed as a voice coil motor.

4. Semiconductor mounting apparatus according to Claim 3, **characterized in that** the first drive device (7) has two separate stators (14a, 14b).

5. Semiconductor mounting apparatus with a slide (6) movable on a frame (5) in a horizontal direction and a first drive device (7) for moving the slide (6) on the frame (5), whereby a chip gripper (1) is secured to the slide (6), **characterized in that** the first drive device (7) comprises a stator (14) having magnets (17) and a coil part (16) with electrical windings (18), wherein the coil part (16) is secured to the slide (6), that the frame (5) is movable in vertical direction by means of a second drive device (8), that the coil part (16) projects in vertical direction into the stator (14) and that the magnets (17) are formed in vertical direction longer than the windings (18) of the coil part (6) so that the geometry between the magnets (17) and the windings (18) determining the drive force does not change on movement of the coil part (16) by a predetermined distance (d) in vertical direction.

6. Semiconductor mounting apparatus according to Claim 5, **characterized in that** the stator (14) is U-shaped and that the coil part (16) projects into its interior space (15).

## Revendications

1. Installation de montage de semi-conducteurs avec un chariot (6) monté sur un cadre, lequel chariot est mobile dans une direction horizontale et un premier dispositif d'entraînement (7) pour bouger le chariot (6) sur le cadre (5); un pince pour puces (1) étant fixé sur le chariot (6), **caractérisé en ce que** le premier dispositif d'entraînement (7) comprend un stator (14) avec des aimants (17) et un induit (16) fixé sur le chariot pourvu d'enroulements (18) électriques, **en ce que** le cadre (5) peut être bougé avec un second dispositif d'entraînement (8) dans une direction verticale, **en ce que** l'induit (16) s'étend dans une direction verticale dans le stator (14) et **en ce que** les enroulements (18) de l'induit (16) sont plus longs dans la direction verticale que les aimants (17) afin de ne pas changer la géométrie qui détermine la force d'entraînement entre les aimants (17) et les enroulements (18) lors d'un déplacement de l'induit (16) selon une distance (d) prédéterminée dans une direction verticale.

2. Installation de montage de semi-conducteurs selon la revendication 1, **caractérisée en ce que** le stator (14) a une forme en U et **en ce que** l'induit (16) s'étend dans son espace intérieur (15).

3. Installation de montage semi-conductrice selon la revendication 1, **caractérisée en ce que** le premier dispositif d'entraînement (7) est formé en tant que moteur « voice coil ».

4. Installation de montage semi-conductrice selon la revendication 3, **caractérisée en ce que** le premier dispositif d'entraînement (7) présente deux stators (14a, 14b) séparés.

5. Installation de montage semi-conductrice avec un chariot (6) monté sur un cadre, lequel chariot est mobile dans une direction horizontale et un premier dispositif d'entraînement (7) pour bouger le chariot (6) sur le cadre (5); une pince pour puces (1) étant fixée sur le chariot (6), **caractérisé en ce que** le premier dispositif d'entraînement (7) comprend un stator (14) avec des aimants (17) et un induit (16) fixé sur le chariot pourvu d'enroulements (18) électriques, **en ce que** le cadre (5) peut être bougé avec un second dispositif d'entraînement (8) dans une direction verticale, **en ce que** l'induit (16) s'étend dans une direction verticale dans le stator (14) et **en ce que** les aimants (17) sont plus longs en direction verticale que les enroulements (18) de l'induit (16) afin de ne pas changer la géométrie qui détermine la force d'entraînement entre les aimants (17) et les enroulements (18) lors d'un déplacement de l'induit (16) selon une distance (d) prédéterminée dans une direction verticale.

6. Installation de montage de semi-conducteurs selon la revendication 5, **caractérisée en ce que** le stator (14) a une forme en U et **en ce que** l'induit (16) s'étend dans son espace intérieur (15).
